# EUROPEAN PATENT APPLICATION

(11) **EP 3 043 361 A1**
(43) Date of publication of application: **13.07.2016**
(21) Application number: 14841524.3
(22) Date of filing: 04.09.2014
(51) Int. Cl.: H01F 7/06, H02K 41/02, H02K 41/03

(54) **ARMATURE COIL FOR ELECTROMAGNETIC ACTUATOR, ELECTROMAGNETIC ACTUATOR, EXPOSURE APPARATUS, AND DEVICE MANUFACTURING METHOD**

(30) Priority: 04.09.2013 JP 2013182925
(71) Applicant: CKD Corporation, Komaki-shi, Aichi 485-8551 (JP); Nikon Corporation, Tokyo 108-6290 (JP)
(72) Inventor: ITO, Akihiro, Komaki-shi Aichi 485-8551 (JP); KOUKETSU, Masayuki, Komaki-shi Aichi 485-8551 (JP); MORIMOTO, Shigeru, Tokyo 108-6290 (JP); YOSHIMOTO, Hiromitsu, Tokyo 108-6290 (JP); TANAKA, Koji, Tokyo 108-6290 (JP)
(74) Representative: Hoffmann Eitle
(86) International application number: PCT/JP2014/073340
(87) International publication number: WO 2015/034005

(57) **Abstract**

Disclosed is an armature coil (60) that constitutes a stator of an X-axis linear motor and that generates a magnetic field by passing a current therethrough, the armature coil comprising: a band-shaped electroconductive layer (62a) that is made of copper and that is wound around a predetermined winding axis; a band-shaped insulating layer (62b) that is provided between opposing surfaces of the electroconductive layer (62a), and that electrically insulates the opposing electroconductive layers (62a) from one another; and bonding layer (62c) that bonds together the opposing surfaces of the electroconductive layer (62a) with the insulating layer (62b) therebetween.

## Description

### TECHNICAL FIELD

The present invention relates to armature coils for electromagnetic actuators, electromagnetic actuators, exposure apparatuses, and device manufacturing methods, and more particularly to an armature coil used in an electromagnetic actuator such as a linear motor, an electromagnetic actuator using the armature coil, an exposure apparatus using the electromagnetic actuator, and a device manufacturing method using the exposure apparatus.

### BACKGROUND ART

Conventionally, in a projection exposure apparatus used in a lithography process for manufacturing electronic devices (microdevices) such as semiconductor devices (such as integrated circuits) or liquid crystal display devices, such as, for example, a projection exposure apparatus of a step-and-repeat method (a so-called stepper) or a projection exposure apparatus of a step-and-scan method (a so-called scanning stepper), an electromagnetic actuator such as a linear motor is used, for position control of a wafer or a glass plate (hereinafter, collectively called a wafer) serving as an exposed subject.

Here, as the armature coil that the electromagnetic actuator used in the exposure apparatus is equipped with, an armature coil which uses an elongated band-shaped wire (so-called strip) as a winding (electroconductive line) is known (e.g., refer to PTL 1).

Now, as the armature coil for the electromagnetic actuator, a more compact coil is desired, while securing the number of windings.

### CITATION LIST

### PATENT LITERATURE

[PTL 1] U.S. Patent No. 6,891,600

### SUMMARY OF THE INVENTION

### SOLUTION TO PROBLEM

The present invention was made under the circumstances described above, and from a first aspect, there is provided an electromagnetic actuator armature coil that is formed with a band-shaped winding wound a plurality of times around a predetermined winding axis, the winding comprising: a band-shaped conductor; and a band-shaped electrical insulator provided at one surface side of the conductor.

According to this, conduction between opposing (overlapping) conductors in a state wound around the winding axis is impeded (electrical short-circuiting is prevented) by the electrical insulator. Because the electrical insulator is formed in a band-shape, diameter in a radial direction of the coil can be reduced when compared with a case in which the whole surface of the conductor is covered with an insulator.

According to a second aspect of the present invention, there is provided (12)an electromagnetic actuator, comprising: the electromagnetic actuator armature coil of the present invention provided at one of a mover and a stator; and a magnetic body provided at an other of the mover and the stator, wherein by an electromagnetic interaction between the electromagnetic actuator armature coil and the magnetic body, a thrust is generated between the electromagnetic actuator armature coil and the magnetic body.

According to a third aspect of the present invention, there is provided an exposure apparatus, comprising: a movable body that moves by the thrust generated by the electromagnetic actuator of the present invention, holding a predetermined obj ect; and a pattern formation apparatus that forms a predetermined pattern on the object held by the movable body, using an energy beam.

According to a fourth aspect of the present invention, there is provided a device manufacturing method, comprising: exposing the object using the exposure apparatus of the present invention; and developing the object which has been exposed.

### BRIEF DESCRIPTION OF DRAWINGS

FIG. 1 is a view schematically showing a structure of an exposure apparatus of an embodiment.
FIG. 2 is a perspective view showing a stage device that the exposure apparatus in FIG. 1 has.
FIG. 3A is a perspective view showing an X-axis stator that the stage device in FIG. 2 has, and FIG. 3B is a perspective view of a coil unit that the stator in FIG. 3A has.
FIG. 4A is a perspective view of a coil that the coil unit in FIG. 3B has, and FIG. 4B is a sectional view of line B-B in FIG. 4A.
FIG. 5 is a block diagram showing an input/output relation of a main controller that mainly structures a control system of the exposure apparatus.

### DESCRIPTION OF EMBODIMENT

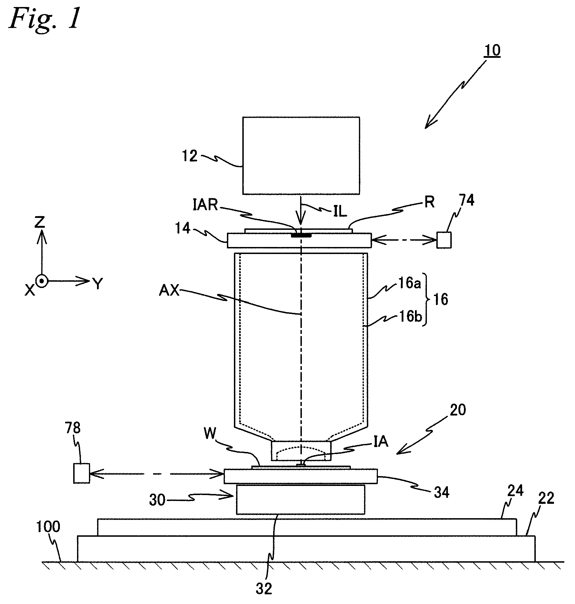

Hereinafter, an embodiment will be described, referring to FIGS. 1 to 5.

FIG. 1 schematically shows a structure of an exposure apparatus 10 according to an embodiment. Exposure apparatus 10 is a projection exposure apparatus of the step-and-scan method, or the so-called scanner. As it will be described later on, in the present embodiment, a projection optical system 16b is provided, and in the description below, the description will be made with a direction parallel to an optical axis AX of projection optical system 16b described as a Z-axis direction, a direction in which a reticle R and a wafer W are relatively scanned in a plane orthogonal to the Z-axis direction described as a Y-axis direction, and a direction orthogonal to the Z-axis and the Y-axis will be described as an X-axis direction, and a rotation (tilt) direction around the X-axis, the Y-axis, and the Z-axis respectively described as a θx direction, a θy direction, and a θz direction.

Exposure apparatus 10 is equipped with parts such as an illumination system 12, a reticle stage 14, a projection unit 16, a stage device 20 including a wafer stage 30, and a control system for these parts. On wafer stage 30, wafer W is mounted that has a resist (photosensitive agent) coated on its surface.

Illumination system 12, as is disclosed in, for example, U.S. Patent Application Publication No. 2003/0025890, includes a light source, and an illuminance equalizing optical system including parts such as an optical integrator, and an illumination optical system that has parts such as a reticle blind (none of which are shown). Illumination system 12 illuminates a slit-shaped illumination area IAR on reticle R set (limited) by a reticle blind (also called a masking system) with an illumination light (exposure light) IL at an illuminance almost uniform. As illumination light IL, for example, an ArF excimer laser beam (wavelength 193 nm) is used.

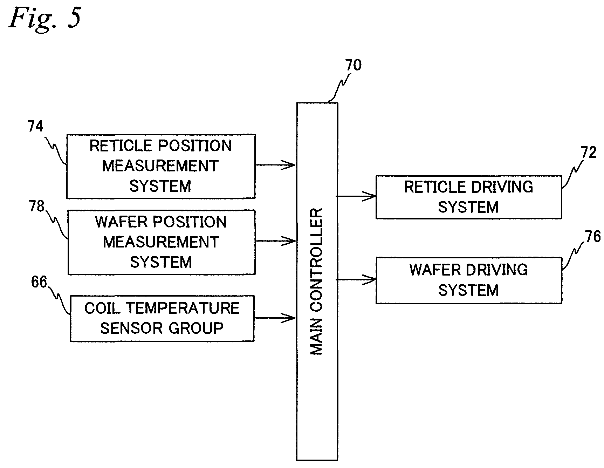

Reticle stage 14 holds a reticle R that has a circuit pattern formed on its pattern surface (a surface on the -Z side in FIG. 1), by, e.g., vacuum suction. Reticle stage 14 is drivable in a scanning direction (the Y-axis direction) with predetermined strokes, and is also finely drivable in the X-axis and the θz directions, by a reticle driving system 72 (not shown in FIG. 1. Refer to FIG. 5) which includes, e.g., an XY two degrees of freedom linear motor (not shown). Position information (including rotation amount information in the θz direction) within an XY plane of reticle stage 14 is obtained by a main controller 70 (not shown in FIG. 1. Refer to FIG. 5), using a reticle position measurement system 74 which includes, e.g., a laser interferometer system (or an encoder system). Main controller 70 controls the position (including rotation amount in the θz direction) in the XY plane of reticle stage 14, by controlling the XY two degrees of freedom linear motor that reticle driving system 72 has, based on the output of reticle position measurement system 74 described above.

Projection unit 16 is placed below (-Z side of) reticle stage 14. Projection unit 16 includes a barrel 16a, and projection optical system 16b held within barrel 16a. As projection optical system 16b, for example, a dioptric system is used, consisting of a plurality of optical elements (lens elements) arranged along optical axis AX. Projection optical system 16b is, for example, double telecentric, and has a predetermined projection magnification (e.g., 1/4 times, 1/5 times, or 1/8 times).

Therefore, when illumination area IAR on reticle R is illuminated by illumination light IL from illumination system 12, by illumination light IL passing through reticle R, which is placed with its pattern surface almost coinciding with a first plane (an object plane) of projection optical system 16b, a reduced image of the circuit pattern of reticle R within illumination area IAR (a reduced image of a part of the circuit pattern) is formed on an area (hereinafter, also called an exposure area) IA conjugate to illumination area IAR on wafer W, which is placed on a second plane (image plane) side of projection optical system 16b, via projection optical system 16b. Then, by reticle R being relatively moved in the scanning direction with respect to illumination area IAR (illumination light IL) and wafer W being relatively moved in the scanning direction with respect to exposure area IA (illumination light IL) according to a synchronous drive of reticle stage 14 and wafer stage 30, scanning exposure of one shot area (divided area) on wafer W is performed, and the pattern of reticle R is transferred onto the shot area. That is, in the present embodiment, the pattern of reticle R is generated on wafer W by illumination system 12 and projection optical system 16b, and by exposure of a sensitive layer (resist layer) on wafer W by illumination light IL, the pattern is formed on wafer W.

Stage device 20 is equipped with parts such as, a frame caster 22 installed on a floor 100 in a clean room, a base board 24 mounted on frame caster 22, a wafer stage 30 placed above base board 24, a wafer driving system 76 (not shown in FIG. 1. Refer to FIG. 5) for driving wafer stage 30, a wafer position measurement system 78 for obtaining position information of wafer stage 30.

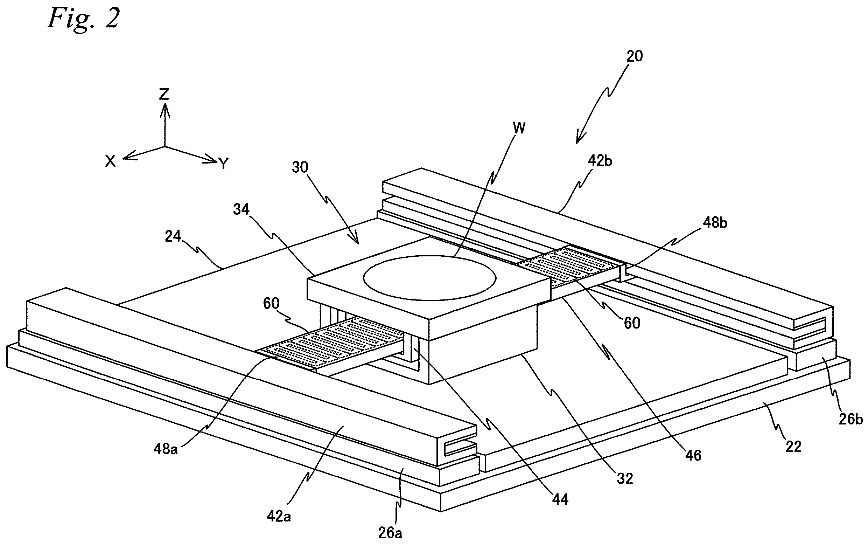

Frame caster 22, as is shown in FIG. 2, consists of a rough flat plate-shaped member, on which protruding sections 26a, 26b, protruding upward and having a longitudinal direction in the Y-axis direction, are formed integrally near the edge at one side and the other side of the X side direction. Above protruding section 26a of frame caster 22, a Y-axis stator 42a extending in the Y-axis direction is mounted. Similarly, above section 26b of frame caster 22, a Y-axis stator 42b extending in the Y-axis direction is mounted. The Y-axis stators 42a and 42b, in the present embodiment, are structured with a magnet unit that has a plurality of permanent magnets placed at a predetermined spacing along the Y-axis direction.

Base board 24 consists of a plate-shaped member called a surface plate, and is placed on frame caster 22 at an area in between protruding sections 26a, 26b. The upper surface of base board 24 has an extremely high degree of flatness, and serves as a guide surface when wafer stage 30 moves.

Wafer stage 30 is equipped with a wafer stage main section 32 placed above base board 24, and a wafer table 34, which is mounted on wafer stage main section 32, via a Z tilt driving mechanism which is not shown. Z tilt driving mechanism includes parts such as, for example, three actuators (e.g. , voice coil motors) that support wafer table 34 on wafer stage main section 32 at three points, and finely drives wafer table 34 in directions of three degrees of freedom; in the Z-axis direction, the θx direction, and the θy direction.

Wafer stage main section 32 consists of a box-shaped member through which a through hole penetrating in the X-axis direction is formed. To the lower surface of wafer stage main section 32, a plurality of air bearings which are not shown is attached. Wafer stage 30 is supported in a non-contact manner above the guide surface previously described via a clearance of around several µm, via the plurality of air bearings. Wafer table 34 consists of an almost square plate-shaped member in a planar view (when viewed from the +Z direction), and on its upper surface, a wafer holder (not shown) that holds wafer W is provided.

Inside wafer stage main section 32, a mover 44 is placed, consisting of a magnet unit that is U-shaped in the YZ section and having a plurality of permanent magnets placed at a predetermined spacing along the X-axis direction.

In between the pair of opposing surfaces of mover 44, an X-axis stator 46 that extends in the X-axis direction is inserted. The X-axis stator 46 is structured by an armature unit that incorporates a plurality of armature coils 60 (hereinafter simply referred to as a coil 60) placed along at a predetermined spacing in the X-axis direction. A moving-magnet-type X-axis linear motor that drives wafer stage 30 in the X-axis direction is structured, by mover 44 consisting of the magnet unit and X-axis stator 46 consisting of the armature unit. In the description below, the X-axis linear motor described above will be appropriately referred to as X-axis linear motor 46, using the same reference sign as the stator (the X-axis stator) 46. Incidentally, as the X-axis linear motor, a moving-coil-type linear motor may also be used.

To the end at one side and the other side in the longitudinal direction of the X-axis stator 46, for example, movers 48a, 48b are respectively fixed, consisting of an armature unit that incorporates a plurality of armature coils (not shown) placed at a predetermined spacing along the Y-axis direction. Each of movers 48a, 48b is inserted in between the pair of opposing surfaces of Y-axis stators 42a, 42b previously described. That is, in the present embodiment, two Y-axis linear motors of a moving-coil-type are structured, by movers 48a, 48b consisting of armature units and the Y-axis stators 42a, 42b consisting of magnet units. In the description below, each of the two Y-axis linear motors described above will also be appropriately referred to as Y-axis linear motors 42a, 42b, using the same reference signs as each of the stators (the Y-axis stators)42a, 42b. Incidentally, as the Y-axis linear motors, moving-magnet-type linear motors may also be used.

Main controller 70 (refer to FIG. 5) drives wafer stage 30 in the X-axis direction by X-axis linear motor 46, and also drives wafer stage 30 integrally with X-axis linear motor 46 in the Y-axis direction by Y-axis linear motors 42a, 42b. Further, main controller 70 also rotationally drives wafer stage 30 in the θz direction by slightly changing the driving force in the Y-axis direction that Y-axis linear motors 42a, 42b generate. In the present embodiment, Y-axis linear motors 42a, 42b, X-axis linear motor 46, and the Z tilt driving mechanism which is not shown that drives wafer table 34 structure wafer driving system 76 shown in FIG. 5, and main controller 70 controls each component that structures wafer driving system 76.

Position information in directions of six degrees of freedom (the X, the Y, the Z, the θx, the θy, and the θz directions) of wafer stage 30 (wafer table 34) structured in the manner described above is obtained with wafer position measurement system 78 (refer to FIG. 5), which includes an interferometer system such as the one disclosed in, for example, U.S. Patent No. 8,059,260. Incidentally, as the measurement system for obtaining the position information of wafer stage 30 in directions of six degrees of freedom, instead of the interferometer system, an encoder system (or a measurement system which is a combination of the interferometer system and the encoder system) such as the one disclosed in, for example, U.S. Patent Application Publication No. 2008/0094592, can be used.

Next, a structure of X-axis stator 46, and a structure of coil 60 that stator 46 has will be described.

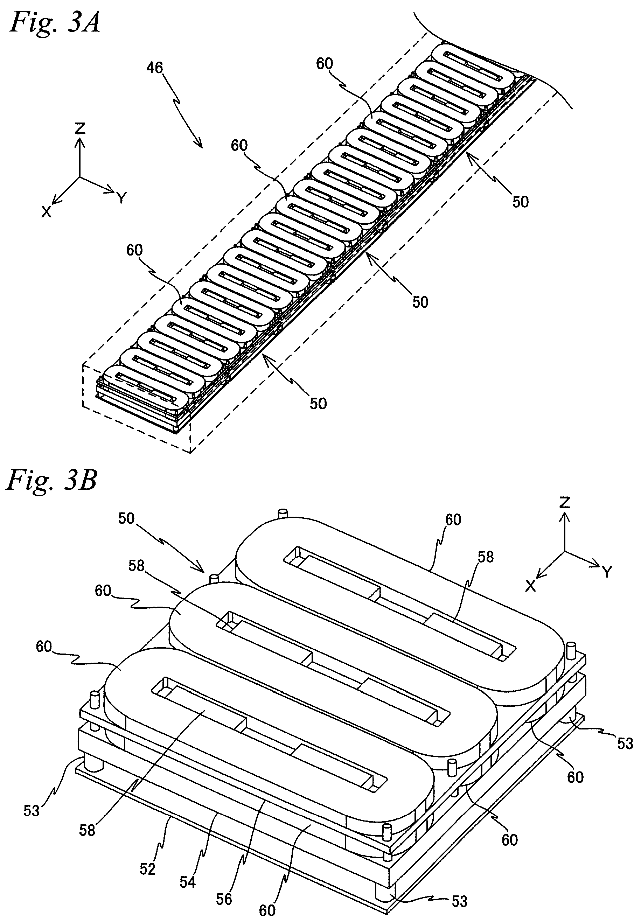

Stator 46, as is shown in FIG. 3A, has a plurality of coil units 50. The plurality of coil units 50 are arranged in a state adjacent to one another in the X-axis direction. FIG. 3B representatively shows a single coil unit of the plurality of coil units 50. Coil unit 50 has parts such as a circuit board 52, a base plate 54, a cooling plate 56, and a plurality of coils 60.

Circuit board 52 consists of a plate-shaped member which is almost square in a planar view, on which parts such as a switching element (not shown) is assembled. Base plate 54 consists of a plate-shaped member which is almost square in a planar view. Circuit board 52 described above is fixed to the lower surface (-Z side surface) of base plate 54 by a screw 53, via a predetermined gap (clearance, gap). Cooling plate 56 consists of a plate-shaped member which is almost square in a planar view, and is placed at the upper surface side of base plate 54, via a predetermined gap. Inside cooling plate 56, a passage (a so-called microchannel) through which a coolant for cooling coil 60 passes is formed.

Coil unit 50 of the present embodiment has, for example, six coils 60. For example, of the six coils 60, three coils 60 are placed in between base plate 54 and cooling plate 56 (the lower surface of cooling plate 56) at a predetermined spacing in the X-axis direction, and the remaining three are placed at the upper surface side of cooling plate 56 at a predetermined spacing in the X-axis direction. Incidentally, the structure of coils 60 placed at the upper surface side of cooling plate 56 and the structure of coils 60 placed at the lower surface side of cooling plate 56 are substantially the same.

On the upper surface of base plate 54 described above, for example, three sets of a pair of projections 58 are formed, projecting in the +Z direction at a predetermined spacing in the X-axis direction. Base plate 54, for example, includes a total of six projections 58, and is formed of an electrically insulating material (such as, for example, a ceramic that uses alumina as a raw material). The pair of projections 58 is inserted into the hollow core part of coils 60. The outer circumference surface of projections 58 and the wall surface which forms the hollow core part of coils 60 are in contact (fitting closely) in a state where there is substantially no gap. This allows the drive reaction force acting on coils 60 when wafer stage 30 (each refer to FIG. 2) is driven in the X-axis direction by X-axis linear motor 46 to be supported by projection 58 (namely, base plate 54). Further, also in cooling plate 56 described above, through holes corresponding to projections 58 (not shown) are formed.

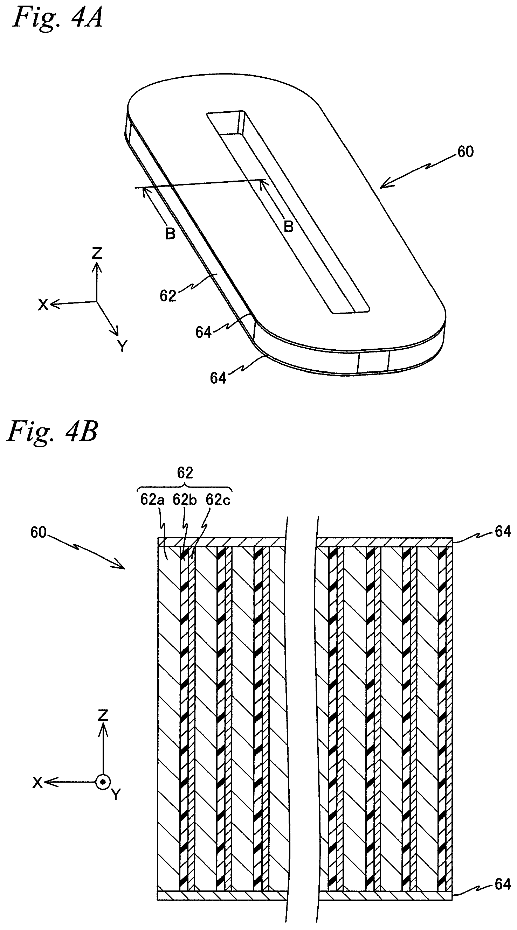

FIG. 4A representatively shows a single coil of the plurality of coils 60 that coil unit 50 has. Coil 60 of the present embodiment is a so-called planar coil (flat coil), which is elliptical in a planar view, and the upper surface and the lower surface respectively are parallel to the XY plane. As is shown in FIG. 3B, the upper surfaces of, e.g., three coils 60, placed at the lower surface side of cooling plate 56 are respectively in contact with the lower surface of cooling plate 56, and the lower surfaces of, e.g. , three coils 60, placed at the upper surface side of cooling plate 56 are respectively in contact with the upper surface of cooling plate 56. Coil unit 50 has a coil temperature sensor group 66 (not shown in FIG. 3B. Refer to FIG. 5) that measures the temperature near coil 60. Main controller 70 (refer to FIG. 5) controls the flow amount of the coolant supplied to cooling plate 56 from a coolant supply device not shown, so that the temperature of coil 60 which generates heat when current is supplied falls within a desired range, based on the output of coil temperature sensor group 66. Incidentally, an additional cooling plate may be placed further to the lower surface side of, e.g. , the three coils 60, placed at the lower surface side of cooling plate 56 and/or further to the upper surface side of, e.g. , the three coils 60, placed at the upper surface side of cooling plate 56.

Referring back to FIG. 4A, coil 60 is formed by a long band-shaped winding 62 (also referred to as a strip) being wound around a winding axis (not shown) parallel to the Z-axis a plurality of times (e.g., about 500 times). Winding 62, as is shown in FIG. 4B, has an electroconductive layer 62a, an insulating layer 62b, and a bonding layer 62c. Electroconductive layer 62a is formed of a so-called copper foil (copper formed into a thin band-shape). Although the thickness of electroconductive layer 62a (copper foil) is not limited in particular, in the present embodiment, the thickness is set to, e.g., around 35µm. Incidentally, the conductive metal material structuring electroconductive layer 62a is not limited to copper, and other conductive materials such as, e.g., aluminum, may also be used.

Insulating layer 62b is formed integral with electroconductive layer 62a, by a synthetic resin material being coated (or a nonconductive film being pasted) on a surface (in the present embodiment, the inner side surface in a state where winding 62 is wound in a coil shape) of the copper foil that structures electroconductive layer 62a described above. As the nonconductive material (electrical insulator) that forms insulating layer 62b, a synthetic resin material can be used, such as, e.g., polyimide, or polyethylene terephthalate. Although the thickness of insulating layer 62b is not limited in particular, in the present embodiment, the thickness is set thinner than the thickness of electroconductive layer 62a to, e.g., around 3µm. Bonding layer 62c is formed integral with insulating layer 62b, by an adhesive agent (or an adhesive) being coated on a surface (a surface opposite to the bonding surface to electroconductive layer 62 of insulating layer 62b) of insulating layer 62b described above. Although the type of adhesive structuring bonding layer 62c is not limited in particular, the adhesive preferably is to have electrical insulation and heat resistance. Although the thickness of bonding layer 62c is not limited in particular, in the present embodiment, the thickness is set thinner than the thickness of insulating layer 62b to, e.g., around 2µm.

Winding 62 has electroconductive layer 62a, insulating layer 62b, and bonding layer 62c described above integrated in advance, and when winding 62 is wound around the winding axis in the process of manufacturing coil 60, bonding layer 62c is adhered to electroconductive layer 62a at the inner periphery side. This inhibits electrical conduction between overlapping electroconductive layers 62a, and prevents short-circuiting.

Further, on the upper surface and lower surface of coil 60, a coating film 64 is formed, which is formed, for example, by spraying a ceramic that uses metal oxide such as alumina as a raw material. This makes the upper surface and the lower surface of coil 60 flat, which restrains a gap from forming (air residing) in between coil 60 and cooling plate 56 (not shown in FIG. 4B. Refer to FIG. 3B), and increases heat exchanging efficiency between coil 60 and cooling plate 56. Incidentally, although it is not shown, the outer circumference surface of winding 62 structuring the outermost circumference surface of coil 60 is covered by, e.g., a synthetic resin material, which prevents electroconductive layer 62a from being exposed outside.

FIG. 5 shows a main structure of a control system of exposure apparatus 10. The control system is structured centering on main controller 70, consisting of a microcomputer (or a workstation) which has overall control over the entire apparatus.

In exposure apparatus 10 (refer to FIG. 1) having the structure described above, first of all, reticle R and wafer W are respectively loaded onto reticle stage 14 and wafer stage 30, and predetermined preparatory operations such as reticle alignment, base line measurement, and wafer alignment (e.g., EGA (Enhanced Global Alignment)) are performed. Then, under the control of main controller 70, reticle stage 14 is driven so that the position of reticle R is set to an acceleration starting position, along with wafer stage 30 being also driven to an acceleration starting position for exposure with respect to the first shot area of wafer W. And then, by reticle stage 14 and wafer stage 30 being synchronous driven along the Y-axis direction, exposure is performed on the first shot area on wafer W. Hereinafter, exposure of wafer W is completed when exposure of all of the shot areas on reticle has been performed.

Including when the alignment operation and the exposure operation described above are performed, in exposure apparatus 10, wafer stage 30 (wafer W) is appropriately driven in directions of six degrees of freedom on base board 24 by wafer driving system 76 (refer to FIG. 5), which includes X-axis linear motor 46, Y-axis linear motors 42a, 42b, and the Z tilt driving mechanism (not shown).

According to the present embodiment described so far, because insulating layer 62b for preventing short circuit between electroconductive layers 62a is provided only on one surface side (the inner surface side in the present embodiment) of the copper foil structuring electroconductive layers 62a in winding 62 of each of the plurality of coils 60 that X-axis linear motor 46 (X-axis stator 46) has, the radial dimension of coil 60 can be reduced than the case when a coil with the same number of windings is made with a winding covered for insulation on the whole surface of the outer circumference of the copper foil which structures the electroconductive layer. This can reduce the size and weight of coil 60. Further, because electroconductive layers 62a overlapping one another are adhered by bonding layer 62c formed by an adhesive, rigidity of coil 60 is increased.

Further, because coil 60 has coating film 64, formed of alumina that is excellent in thermal conductivity on a contact surface with cooling plate 56, coil 60 that has generated heat with energization can be cooled efficiently. This can restrain a temperature distribution (or a temperature gradient) from occurring in exposure apparatus 10, which allows exposure operation to be performed with high precision. Further, because the rigidity (e.g., torsion rigidity in a direction intersecting the XY plane) of coil 60 increases due to the function of coating film 64, coil 60 can be handled easily. Further, while coil 60 of the present embodiment does not have both edges (edges on the +Z and -Z sides in FIG. 4B) in the width direction of electroconductive layers 62a covered for insulation, because coating film 64 of alumina ceramics excellent in electrical insulation is formed on the upper surface and the lower surfaces, exposure of electroconductive layers 62a to the outside is prevented.

Incidentally, the structure of exposure apparatus 10 in the embodiment above can be appropriately changed. For example, in the embodiment above, while the case has been described where the electromagnetic actuator having coil 60 is a one degree of freedom motor (X-axis linear motor 46), as the electromagnetic actuator, a six degrees of freedom planar motor may be used as is disclosed in, for example, U.S. Patent Application Publication No. 2013/0164687, and as the winding structure of the coil used in the stator (or mover) of the six degrees of freedom planar motor, a structure similar to coil 60 in the embodiment described above may be applied.

Further, the electromagnetic actuator is not limited to a linear motor, and may be a rotary motor, and as the winding structure of the coil used in the mover (or stator) of the rotary motor, a structure similar to coil 60 in the embodiment described above may be applied. Furthermore, when the electromagnetic actuator is a linear motor, the linear motor may be a two degrees of freedom (directions of orthogonal two axes) linear motor or a three degrees of freedom (directions of orthogonal two axes and a direction around a plane including the orthogonal two axes) planar motor, and as the winding structure of the coil used in the mover (or stator) of the linear motor, a structure similar to coil 60 in the embodiment described above may be applied. Further, the coil may be other shapes, such as almost a square, a triangle, or a trapezoid in a planar view.

Further, in the embodiment described above, while coil 60 is formed of winding 62 having a three-layered structure (the surface being electroconductive layer 62a and the rear surface being bonding layer 62c) in which electroconductive layer 62a is provided at one surface side of insulating layer 62b, and bonding layer 62c is provided at the other surface side of insulating layer 62b, the structure of winding 62 is not limited to this, and may have a structure that is, e.g., a three-layered structure (the surface being insulating layer 62b and the rear surface being bonding layer 62c) in which insulating layer 62b is provided at one surface side of electroconductive layer 62a and bonding layer 62c is provided at the other surface side of electroconductive layer 62a. Further, contrary to the embodiment described above, the surface may be bonding layer 62c and the rear surface may be electroconductive layer 62a.

Further, in the embodiment described above, while coating film 64 which protects each of the upper surface and the lower surface of coil 60 is formed of ceramics, this is not limiting, and the film may be formed of, e.g. , a synthetic resin material. Further, coating film 64 may be provided at only one of the upper surface and the lower surface of coil 60, or may not necessarily have to be provided. Further, in coil 60 of the embodiment described above, while overlapping electroconductive layers 62a were adhered by bonding layer 62c via insulating layer 62b, bonding layer 62c may not be necessary as long as the rigidity can be secured by coating film 64. Further, in the embodiment described above, while electroconductive layer 62a and insulating layer 62b were integrated, these may be separated, and the coil may be formed, for example, by preparing a band-shaped conductor and a band-shaped electrical insulator, and integrally winding the conductor and the electrical insulator so that the electrical insulator is interposed in between the overlapping conductors.

Further, as the wafer stage device, other than the wafer stage for holding wafer W, as is disclosed in, for example, U.S. Patent No. 8,059,260, the stage device may have a measurement stage equipped with measuring instruments used to perform various measurements related to exposure, and as the winding structure of the coil used in the stator (or mover) of the linear motor for driving the measurement stage, a structure similar to coil 60 in the embodiment described above may be applied. Further, the wafer stage device may be equipped with two wafer stages like the exposure apparatus disclosed in, for example, U.S. Patent Application Publication No. 2010/0066992. Further, as the winding structure of the coil used in the stator (or mover) for driving the linear motor of reticle stage 14, a structure similar to coil 60 in the embodiment described above may be applied.

Further, while the electromagnetic actuator in the embodiment described above was used for position control of the target subject to processing (so-called work) in the exposure apparatus, this is not limiting, and the actuator may be used, for example, in a motor that a work carrier device (a so-called loading device) has, and as the winding structure of the coil used in the mover (or stator) of the motor, a structure similar to coil 60 in the embodiment described above may be applied.

Further, the electromagnetic actuator may be used in devices other than the exposure apparatus; in a portable device such as a camera or a mobile phone, or self-propelled equipment such as an automobile.

Further, the electromagnetic actuator is not limited to a linear motor or a rotary motor, and may also include an electromagnet.

Further, in the exposure apparatus, illumination light IL is not limited to an ArF excimer laser beam (wavelength 193nm), and may also be an ultraviolet light such as a KrF excimer laser beam (wavelength 248nm), or a vacuum-ultraviolet light such as an F2 excimer laser beam (wavelength 157nm). As is disclosed in, for example, U.S. Patent No. 7,023,610, a harmonic wave may be used, in which an infrared or a visible range single-wavelength laser beam emitted by a DFB semiconductor laser or a fiber laser as a vacuum-ultraviolet light is amplified by a fiber amplifier doped with, e.g. , erbium (or both erbium and ytterbium), and wavelength conversion to an ultraviolet light is performed using a nonlinear optical crystal. Further, the wavelength of illumination light IL is not limited to light of 100 nm or more, and light of a wavelength less than 100 nm may also be used, and the embodiment described above can also be applied, for example, to an EUV exposure apparatus that uses EUV (Extreme Ultraviolet) light in the soft X-ray region (e.g., wavelength band of 5 to 15 nm). Other than this, the embodiment described above can be applied also to an exposure apparatus that uses charged particle beams, such as an electron beam or an ion beam.

Further, the projection optical system of the exposure apparatus in the embodiment described above is not limited to a reduction system, and may be an equal magnifying or a magnifying system, and projection optical system 16b is not limited to a refractive system, and may also be a reflection system or a catadioptric system, and the projection image may be an inverted image or an erected image.

Further, in the embodiment described above, while a transmissive mask (reticle) was used, which is a transmissive substrate on which a predetermined light shielding pattern (or a phase pattern or a light attenuation pattern) is formed, instead of this reticle, as is disclosed in, for example, U.S. Patent No. 6, 778, 257, an electron mask (which is also called a variable shaped mask, an active mask or an image generator, and includes, for example, a DMD (Digital Micromirror Device) that is a type of a non-emission type image display device (spatial light modulator) or the like) on which a light-transmitting pattern, a reflection pattern, or an emission pattern is formed according to electronic data of the pattern that is to be exposed, may also be used.

Further, the embodiment described above can also be applied to a so-called liquid immersion exposure apparatus like the one disclosed in, for example, U.S. Patent No. 8, 004, 650, which performs exposure operation in a state where liquid (e.g., pure water) is filled in between the projection optical system and the exposure target (e.g., wafer).

Further, as is disclosed in, for example, International Publication No. WO 2001/035168, the embodiment described above can also be applied to an exposure apparatus (lithography system) that forms a line-and-space pattern on wafer W by forming interference fringes on wafer W. Further, the embodiment described above can also be applied to a reduction projection exposure apparatus employing a step-and-stitch method that synthesizes a shot area and a shot area.

Further, as is disclosed in, for example, U.S. Patent No. 6,611,316, the embodiment described above can also be applied to an exposure apparatus that synthesizes two reticle patterns on a wafer via a projection optical system, and almost simultaneously performs double exposure on a shot area on the wafer by performing scanning exposure once.

Further, the object on which a pattern is to be formed (the object being the exposure target on which an energy beam is irradiated) in the embodiment described above is not limited to a wafer, and can be other objects such as a glass plate, a ceramic substrate, a film member, or a mask blank.

Further, the use of the exposure apparatus is not limited only to the exposure apparatus for manufacturing semiconductors, but the embodiment above can also be widely applied, for example, to an exposure apparatus for transferring a liquid crystal display devices pattern onto a square-shaped glass plate, or to an exposure apparatus that produces parts such as organic ELs, thin-film magnetic heads, imaging devices (such as CCDs), micromachines, and DNA chips. Further, the embodiment described above can be applied not only to the exposure apparatus that produces microdevices such as semiconductor devices, but also to an exposure apparatus that transfers a circuit pattern onto a glass substrate or silicon wafer to produce a reticle or mask used in a light exposure apparatus, an EUV exposure apparatus, an X-ray exposure apparatus, an electron-beam exposure apparatus, and the like.

Electronic devices such as semiconductor devices are manufactured through the steps such as; a step for performing function/performance design of a device, a step for making a reticle based on this design step, a step for making a wafer from a silicon material, a lithography step for transferring a pattern of a mask (reticle) onto the wafer by the exposure apparatus (pattern formation apparatus) and the exposure method related to the embodiment previously described, a development step for developing the wafer which has been exposed, an etching step for removing by the etching an exposed member of an area other than the area where the resist remains, a resist removing step for removing the resist that is no longer necessary since etching has been completed, a device assembly step (including a dicing process, a bonding process, and a package process), and an inspection step. In this case, in the lithography step, because the device pattern is formed on the wafer using the exposure apparatus of the embodiment described above and performing the exposure method previously described, a highly integrated device can be manufactured with good productivity.

### INDUSTRIAL APPLICABILITY

As is described so far, the armature coil for the electromagnetic actuator of the present invention is suitable for used in an electromagnetic actuator. Further, the electromagnetic actuator of the present invention is suitable for generating a predetermined thrust. Further, the exposure apparatus of the present invention is suitable for forming a predetermined pattern on an object. Further, the device manufacturing method of the present invention is suitable for manufacturing microdevices.

### REFERENCE SIGNS LIST

10··· exposure apparatus, 20··· stage device, 30··· wafer stage, 46··· the X-axis linear motor (the X-axis stator), 50··· coil unit, 60··· coil, 62···winding, 62a··· electroconductive layer, 62b··· insulating layer, 62c··· bonding layer, 64··· coating film, 70··· main controller, W··· wafer

## Claims

1. An electromagnetic actuator armature coil that is formed with a band-shaped winding wound a plurality of times around a predetermined winding axis, wherein
the winding comprises:
a band-shaped conductor; and
a band-shaped electrical insulator provided at one surface side of the conductor.

2. The electromagnetic actuator armature coil according to claim 1, wherein
the conductor and the electrical insulator are integrally formed.

3. The electromagnetic actuator armature coil according to one of claims 1 and 2, wherein
the electrical insulator is provided at an inner circumferential surface side of the conductor, in a state where the winding is wound around the winding axis.

4. The electromagnetic actuator armature coil according to any one of claims 1 to 3, wherein
the conductor and the electrical insulator are formed having almost the same width.

5. The electromagnetic actuator armature coil according to any one of claims 1 to 4, wherein
the winding further has a bonding layer that adheres the conductors, the conductors mutually overlapping via the electrical insulator.

6. The electromagnetic actuator armature coil according to claim 5, wherein
the electrical insulator and the bonding layer are integrally formed.

7. The electromagnetic actuator armature coil according to any one of claims 1 to 6, further comprising:
a coating film which covers at least one of a first surface formed at an end on one side in a width direction of the winding, and a second surface formed at an end on the other side in the width direction of the winding.

8. The electromagnetic actuator armature coil according to claim 7, wherein
the coating film is formed of an electrical insulator.

9. The electromagnetic actuator armature coil according to claim 8, wherein
the coating film is formed by thermal spray of a metal-oxide based ceramic.

10. The electromagnetic actuator armature coil according to any one of claims 7 to 9, wherein
the first surface and the second surface are parallel.

11. The electromagnetic actuator armature coil according to any one of claims 1 to 10, wherein
the electrical insulator is thinner than the conductor.

12. An electromagnetic actuator, comprising:
the electromagnetic actuator armature coil according to any one of claims 1 to 11 provided at one of a mover and a stator; and
a magnetic body provided at the other of the mover and the stator, wherein
by an electromagnetic interaction between the electromagnetic actuator armature coil and the magnetic body, a thrust is generated between the electromagnetic actuator armature coil and the magnetic body.

13. An exposure apparatus, comprising:
a movable body that moves by the thrust generated by the electromagnetic actuator according to claim 12, holding a predetermined object; and
a pattern formation apparatus that forms a predetermined pattern on the object held by the movable body, using an energy beam.

14. A device manufacturing method, comprising:
exposing the object using the exposure apparatus according to claim 13; and
developing the object which has been exposed.
